# EUROPEAN PATENT SPECIFICATION

(11) **EP 0 355 951 B1**
(45) Date of publication and mention of the grant of the patent: **09.08.1995**
(21) Application number: 89305217.5
(22) Date of filing: 23.05.1989
(51) Int. Cl.: H01L 27/115, H01L 21/82, H01L 29/08, G11C 17/00

(54) **Semiconductor device with memory cell region and a peripheral circuit and method of manufacturing the same**
Halbleiteranordnung mit einem Gebiet für Speicherzellen und mit peripherischer Schaltung und Herstellungsverfahren dafür
Dispositif semi-conducteur comportant une région pour cellule de mémoire et comportant un circuit périphérique et son procédé de fabrication

(30) Priority: 25.05.1988 JP 125634/88
(43) Date of publication of application: 28.02.1990
(73) Proprietor: SEIKO EPSON CORPORATION, Shinjuku-ku Tokyo-to (JP)
(72) Inventor: Maruo, Yukata, Suwa-shi Nagano-ken (JP)
(74) Representative: Sturt, Clifford Mark

(56) References cited:
- US-A- 4 037 242
- US-A- 4 663 645
- PATENT ABSTRACTS OF JAPAN vol. 8, no. 285 (E-287)(1722) 26 December 1984 & JP-A-59 151 469

## Description

The present invention relates to a semi-conductor device and, more particularly, to a high breakdown voltage semi-conductor device, and to a method of manufacturing such a device.

High breakdown voltage electrically erasable and programmable read only memories (EEPROMs) are under development as the non-volatile memory of the next generation and are expected to take the place of conventional semi-conductor memories such as the programmable read only memory (PROM) and the erasable and programmable read only memory (EPROM).

In an EPROM or EEPROM that has a peripheral circuit constituted by complementary metal oxide semi-conductor (CMOS) circuitry, n-channel metal oxide semi-conductor (MOS) transistors are generally employed to form memory cells. In this case, each memory cell of an EPROM, wherein data is not electrically erasable, is constituted by a single memory transistor, whereas each memory cell of a high breakdown voltage EEPROM, wherein data is electrically erasable, is formed from a combination of a memory transistor and a select transistor (also known as a "word transistor"). These transistors are coupled together and both must generally be n-channel high breakdown voltage transistors.

On the other hand, p-channel MOS high breakdown voltage transistors in the peripheral circuit are used only for voltage adjusting purposes or the like, and therefore the number of p-channel high breakdown voltage transistors required is smaller than that of the n-channel high breakdown voltage transistors used for the memory cells.

In particular, in the case of an an EEPROM, each memory cell generally comprises a combination of an n-channel FAMOS transistor providing the memory transistor and an n-channel MOS transistor providing the select transistor, these two transistors being coupled together at an n-type diffused region which is used commonly as the drain of the memory transistor and the source of the select transistor. The n-channel FAMOS transistor is formed with a multi-layer gate structure having both a control gate and a floating gate, in which data is written.

The above described prior art is disclosed in the following representative documents:
1. Japanese Patent No. 58-6237 (1983);
2. Japanese Laid Open Patent Publication No. 59-151469 (1984);
3. Japanese Laid Open Patent Publication No. 61-154078 (1986).

Japanese Patent No. 58-6237 discloses a memory cell for an electrically erasable and programmable non-volatile semi-conductor device, which memory cell is formed using a FAMOS transistor having a double layer gate structure.

Japanese Laid Open Patent Publication No. 59-151469 discloses a structure for a protective circuit element which is applicable to a high breakdown voltage MOS field effect transistor and which constitutes a transistor having off-set regions provided either under a thick insulating film formed on a substrate or under a thick insulating film formed on a part of the surface of a substrate by subjecting it to local oxidation. The off-set regions have a lower impurity concentration than those portions of source and drain regions which are in contact with connections leading from the source and drain regions. Such a transistor is hereinafter referred to as a "LOCOS (local oxidation of silicon) off-set transistor".

Japanese Laid Open Patent Publication No. 61-154078 discloses a high breakdown voltage MOS field effect transistor wherein a source and a drain each comprise two regions having different impurity concentrations, as in the case of the so called lightly doped drain (LDD) structure. Such regions may be formed either by a resist pattern obtained utilising a mask or by a side wall insulating film on each side wall of a gate electrode, and that region in each of the source and the drain which is closer to the channel and which has a relatively low impurity concentration is defined as an off-set region. Such a transistor is hereinafter referred to as a "masked off-set transistor".

An EPROM device in which both the transistors of the memory cells and the transistors of the peripheral circuits have an LDD structure is known from US-A-4 663 645.

In conventional semi-conductor devices of the type described above, that is semi-conductor memories having non-volatile memory cells, two different types of transistor, namely p- and n-channel masked off-set transistors and p- and n-channel LOCOS off-set transistors, are produced separately from each other. Accordingly, in a conventional semi-conductor device of the type described above, all the p- and n-channel transistors are either masked off-set transistors or LOCOS off-set transistors.

The respective features of the above mentioned two types of transistor will be explained next.

The masked off-set transistor has a relatively small occupied area and is therefore advantageous for achieving miniaturisation (and therefore high integration). But on the other hand, it has the disadvantage that a mask or a special process is needed to form the off-set regions, which are defined by diffused regions having a relatively low concentration (e.g. p ⁻ or n ⁻).

In contrast, the LOCOS off-set transistor, which includes a thick oxide film above each off-set region, requires a relatively large area and is therefore disadvantageous as far as miniaturisation is concerned. However, it has the advantage that there is no need for a special purpose mask to form the off-set regions defined by low concentration (e.g. p ⁻ or n ⁻) diffused regions and hence the number of manufacturing steps needed is smaller than in the case of the masked off-set structure.

Accordingly, there is a demand for a structure wherein, in the case where both n- and p-channel transistors are required to have a high breakdown voltage, one of the two types of transistor, which is needed in a relatively large number, is formed utilising the masked off-set structure, while the other type of transistor, which is not needed in a large number, is formed utilising the LOCOS off-set structure, taking the above described advantages and disadvantages of the two different types of off-set structure into consideration.

According to a first aspect of the present invention, there is provided a semi-conductor device having a memory cell region and a peripheral circuit on a common substrate, the memory cell region including a plurality of memory transistors each defined by a first high breakdown voltage transistor of a first conductivity type and a plurality of select transistors each defined by a second high breakdown voltage transistor of the first conductivity type, and the peripheral circuit including a third high breakdown voltage transistor of a second conductivity type, wherein the first and second high breakdown voltage transistors each have a first off-set region of the first conductivity type defined by a low concentration impurity region having a substantially flat surface, each first off-set region being formed in the substrate adjacent to a respective gate electrode of the first and second high breakdown voltage transistors, and in that the third high breakdown voltage transistor has a thick insulating film provided adjacent to a gate electrode of the third high breakdown transistor with a part thereof buried in the substrate, and a second off-set region of the second conductivity type defined by a low concentration impurity region provided in the substrate under the thick insulating film.

Such a device is advantageous from the viewpoint of miniaturisation and simplification of the manufacturing process since, for example, there is a reduction in the number of masks needed.

In the described embodiment, the memory transistors and the select transistors of the memory cell region are, for example, n-channel high breakdown voltage transistors, defined by masked off-set MOS transistors, provided in a relatively large number. The peripheral circuit comprises, for example, p-channel high breakdown voltage transistors which are defined by LOCOS off-set MOS transistors provided in a relatively small number and, for example, n-channel high breakdown voltage transistors which are defined by masked off-set MOS transistors.

According to a second aspect of the present invention, there is provided a method of manufacturing a semi-conductor memory device having a first high breakdown voltage transistor of a first conductivity type and a second high breakdown voltage transistor of a second conductivity type on a common substrate, said method comprising forming a second low impurity off-set region of the second conductivity type in a first conductivity type region of the semi-conductor substrate and a stopper region of the second conductivity type in a second conductivity type region of the semi-conductor substrate; forming a thick insulating film on the second off-set region with a portion thereof buried in the semi-conductor substrate; forming a gate electrode of the first high breakdown voltage transistor above the second conductivity type region of the semi-conductor substrate and a gate electrode of the second high breakdown voltage transistor above the first conductivity type region of the semiconductor substrate adjacent the second off-set region; forming a first low impurity off-set region of the first conductivity type in the semi-conductor substrate adjacent the gate electrode of the first high breakdown voltage transistor; forming source and drain regions of the first high breakdown voltage transistor in the semiconductor substrate adjacent the first off-set region and distal to the gate electrode of the first high breakdown transistor, and forming source and drain regions of the second high breakdown voltage transistor in the semiconductor substrate adjacent to the second off-set region and distal to the gate electrode of the second high breakdown transistor.

In one example of the method described herein, after an n-well has been formed in a LOCOS off-set transistor forming region of a p-type semi-conductor substrate, a p-type channel stopper region is formed around a masked off-set transistor forming region outside the n-well and also in a region which is under each edge of a location for forming a gate of a LOCOS off-set transistor. An n-type channel stopper region is formed around the inside of the n-well in contact with the p-type channel stopper region, and then the surfaces of the p- and n-type channel stopper regions are subjected to local oxidation to form a LOCOS oxide film, thereby simultaneously forming isolation regions defined by a combination of the LOCOS oxide film and the p- and n-type channel stopper regions and the p-type LOCOS off-set regions. Further, gate electrodes, which are made of the same poly-crystalline silicon, are respectively formed in the LOCOS off-set transistor forming region and the masked off-set transistor forming region, and after n-type low concentration diffused layers have been formed, with the gate electrode in the masked off-set transistor forming region used as a mask, an n-type impurity is introduced, with a resist covering the gate electrode used as a mask, to form source and drain regions defined by high concentration diffused layers, thereby forming a masked off-set transistor having an LDD structure. Then, with the gate electrode in the LOCOS off-set transistor forming region used as a mask, a p-type impurity is introduced into the LOCOS off-set transistor forming region to form source and drain regions defined by high concentration diffused layers, thereby forming a p-channel LOCOS off-set transistor. In this process, the above described conductivity types, p- and n-, may be substituted for one another. The term "MOS" is employed to imply also MIS in the present invention.

Thus, according to the present invention, as defined in the attached claims, high breakdown voltage transistors, for use, for example, in a semi-conductor memory such as an EEPROM, are formed utilising two different types of off-set structure, that is the masked off-set structure and the LOCOS off-set structure, and with the two different types of off-set transistor formed on the same substrate.

More specifically, either one of the two types of transistor, namely n- and p-channel types of transistor, that is required in a relatively large number is formed utilising the masked off-set structure, which is advantageous in relation to miniaturisation although the number of manufacturing steps increases a little, while the other type of transistor that is used, for example, for a part of a peripheral circuit but is not required in a large number is formed utilising the LOCOS off-set structure, which is unsuitable for miniaturisation but causes no increase in the number of manufacturing steps. Therefore, optimisation is achieved with respect to both the quality and quantity of these high breakdown voltage transistors. Thus, it is possible to form memory circuit elements at the same time without waste.

The invention will be described further, by way of example, with reference to the accompanying drawings, in which:-
Figure 1 is a fragmentary sectional view showing an arrangement of high breakdown voltage CMOS transistors according to the present invention;
Figure 2 (a) is a plan view of a memory cell region of an EEPROM embodying the invention and employing high breakdown voltage n-channel transistors;
Figure 2 (b) is a sectional view taken along the line L - L′ of Figure 2 (a);
Figure 2 (c) is a diagram showing an equivalent circuit for the memory cell shown in Figure 2 (a); and
Figures 3 (a) to 3 (k) are sectional views showing sequentially the steps in a method of manufacturing high breakdown voltage CMOS transistors, similar to those shown in Figure 1, according to the present invention.

Embodiments of the present invention will now be described in detail, with reference to the accompanying drawings, in which like reference numerals denote like elements.

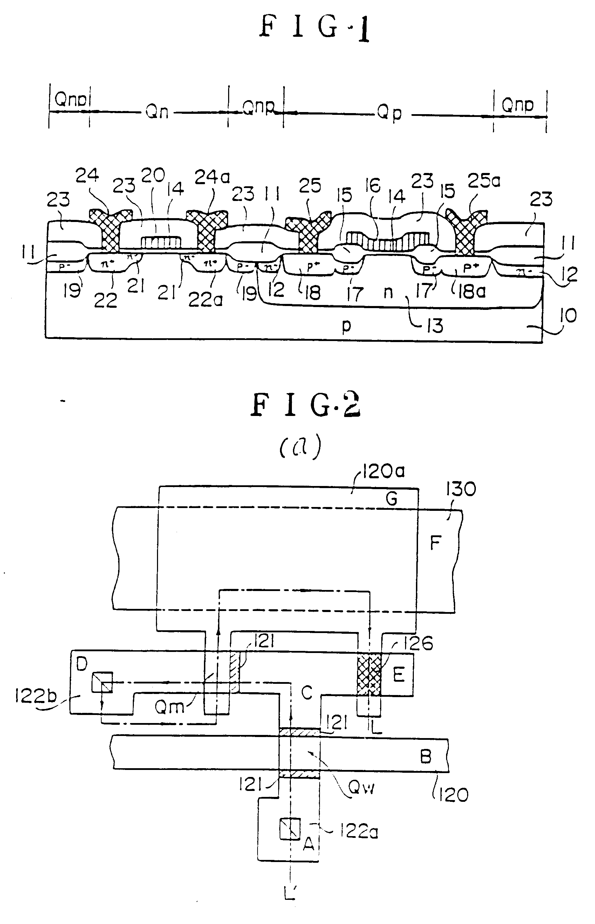

Figure 1 illustrates an arrangement of high breakdown voltage CMOS transistors comprising an n-channel masked off-set MOS transistor Qn (hereinafter referred to as the transistor "Qn"), and a p-channel LOCOS off-set MOS transistor Qp (hereinafter referred to as the transistor "Qp"). The reference symbol Qnp denotes isolation regions formed by LOCOS.

The transistor Qp is formed in an n-well region 13 of a second conductivity type which is surrounded by an isolation region comprising a LOCOS oxide film 11, locally formed on a p-type semi-conductor substrate 10 of a first conductivity type and serving as a field oxide film, and an n⁻-type channel stopper region 12 formed under the LOCOS oxide film 11. A region of a gate oxide film 14 has LOCOS oxide films 15 with a relatively small area formed around it. A gate electrode 16 is formed from a poly-crystalline silicon layer so as to extend over the region of the gate oxide film 14 and part of the LOCOS oxide films 15. P⁻-type off-set regions 17 are provided under the LOCOS oxide films 15, and p⁺-type diffused layers 18 and 18a are provided to serve as source/drain regions of the transistor Qp.

On the other hand, the transistor Qn is formed in an area surrounded by an isolation region comprising the LOCOS oxide film 11 and a p⁻-type channel stopper region 19 provided under the LOCOS oxide film 11. A gate electrode 20 is formed on a further region of the gate oxide film 14, and n⁺-type diffused layers 22 and 22a which serve as source/drain regions of the transistor Qn are provided below this region of the gate oxide film 14 so as to be in connection with respective n⁻-type off-set regions 21. The transistor Qn having a masked off-set structure is thus formed on the same substrate as the transistor Qp having a LOCOS off-set structure.

An inter-layer insulating film 23 is defined by an oxide film or PSG (including BPSG) film. Aℓ films 24 and 24a provide inter-connecting leads from the source/drain regions of the transistor Qn, while Aℓ films 25 and 25a provide inter-connecting leads from the source/drain regions of the transistor Qp.

Since the operation of the high breakdown voltage CMOS transistor arrangement comprising the transistors Qp and Qn according to the present invention is the same as that of the prior art, description thereof is omitted.

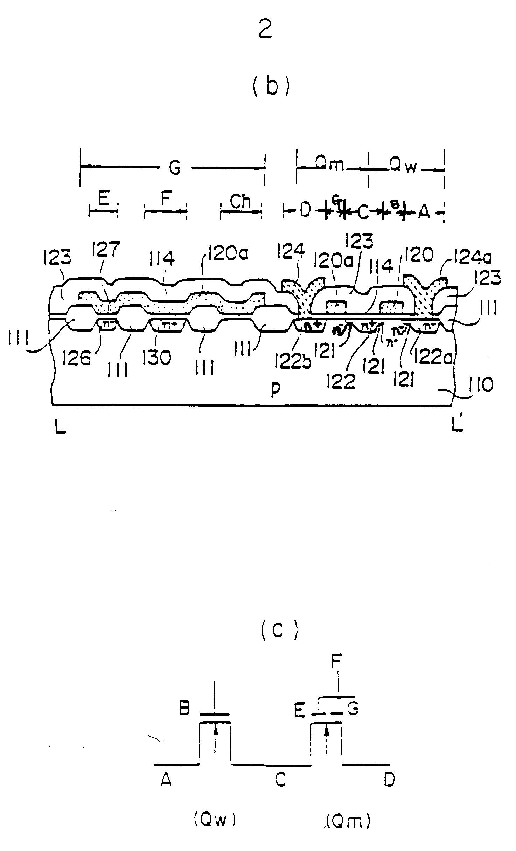

Figure 2 (a) shows a memory cell region of an EEPROM embodying the invention, the illustrated memory cell comprising a memory transistor and a select transistor.

This embodiment features a high breakdown voltage EEPROM which employs n-channel transistors to form each memory cell and a combination of p- and n-channel transistors to form a peripheral circuit and wherein the n-channel transistors that are employed in a relatively large number, mainly for providing the memory cells, are formed utilising the masked off-set structure, while the p-channel transistors that are employed in a relatively small number are formed utilising the LOCOS off-set structure. One example will now be described.

In the equivalent circuit shown in Figure 2 (c), the portion comprising a drain A, a gate B and a source/drain C constitutes an n-channel select transistor (hereinafter referred to as the transistor "Qw"), while the portion comprising the source/drain C, a source D, a floating gate G, a control gate F and a source/drain field region E constitutes a memory transistor (hereinafter referred to as the transistor "Qm) having a FAMOS structure. The two transistors Qw and Qm are coupled together through the common source/drain C, as illustrated. In Figure 2 (a), 2 (b) and 2 (c), the references A to G, Qw and Qm denote the same elements. The memory cells of this embodiment have a memory structure adapted for a high breakdown voltage EEPROM of the type which has a single layer of poly-crystalline silicon, as described below.

The arrangement of the transistors providing the illustrated memory cell structure will be explained below with reference to Figure 2 (b).

LOCOS oxide film 111, serving as a field oxide film, is formed on a p-type semi-conductor substrate 110, the LOCOS oxide film 111 defining isolation regions. P-type channel stopper regions (not shown) are formed under the LOCOS oxide film 111.

The transistor Qw, which is an n-channel masked off-set high breakdown voltage transistor, comprises a drain 122a (corresponding to the drain A) defined by an n⁺-type diffused layer, a gate electrode 120 (corresponding to the gate B) defined by a poly-crystalline silicon layer, and a source 122 (corresponding to the source/drain C) defined by an n⁺-type diffused layer and has a masked off-set structure formed by an n⁻-type offset region 121 and the source/drain regions 122 and 122a. The transistor Qw is generally called a "select transistor" or a "word transistor" from the functional point of view.

The transistor Qm, which adjoins the transistor Qw and which is a single side masked off-set n-channel high breakdown voltage transistor, comprises a source 122b defined by an n⁺-type diffused layer, the source/drain region 122, the n⁻-type off-set region 121 and a gate electrode 120a defined by the poly-crystalline silicon layer. The transistor Qm has a FAMOS structure as serves as a memory transistor which includes a floating gate portion G explained below.

The floating gate portion G includes a channel region Ch, the control gate F, which is defined by an n⁺-type diffused layer 130, and the tunnel region E, which is defined by an n⁺-type diffused layer 126. In contrast to a typical conventional EEPROM wherein a gate electrode is formed from two layers of poly-crystalline silicon, a floating gate, and a control gate provided over the floating gate, the illustrated structure is formed using a single layer of poly-crystalline silicon and has a control gate defined by the n⁺-type diffused layer 130 formed in the substrate 110. An inter-layer insulating film 123 is provided over the gate electrodes 120, 120a, while Aℓ layers 124 and 124a respectively serve for connections from the source/drain regions 122b and 122a, the layers 124 and 124a being formed through openings provided in the inter-layer insulating film 123.

In this way, masked off-set transistors provide the relatively large number of n-channel transistors which are required to form the memory cells, while LOCOS off-set transistors, such as the transistor Qp shown in Figure 1, provide the relatively small number of p-channel transistors which are required in a part of the peripheral circuit, thereby achieving miniaturisation and simplification of the manufacturing process and thus optimising the resulting EEPROM.

The operation of a memory cell, such as the one shown in Figure 2, will now be described.

To write or erase data, a voltage in the region from about 15 V to 20 V is applied between the tunnel region 126 and the control gate 130 thereby to apply a field of about 10 MV/cm or more to a thin tunnel oxide film 127 (thickness 100 Angstrom) between the floating gate 120a and the tunnel region 126. In consequence, electrons are injected into or released from the floating gate 120a through the tunnel oxide film 127 by the well known phenomenon, Fowler-Nordheim tunnelling. When electrons are injected, data is electrically erased, whereas when electrons are released, data is electrically written.

More specifically, when electrons are injected into the floating gate 120a, the threshold voltage of the memory transistor Qm is raised, whereas when electrons are released, the threshold voltage is lowered. Accordingly, when a voltage, which lies between two threshold.voltages set respectively as a result of the injection and release of electrons, is applied to the control gate 130, the memory transistor Qm remains OFF if electrons have previously been injected into the floating gate 120a, whereas, the transistor Qm is turned ON if electrons have previously been released therefrom, thus enabling discrimination between the ON and OFF states of the memory transistor Qm. It is therefore possible to achieve an EEPROM which is similar to a conventional FLOTOX (floating gate tunnel oxide) device having a double layer gate structure.

The single layer gate structure according to this embodiment has the advantage that the slope of the steps or edges of the openings provided in the inter-layer insulating film 123 for the Aℓ connections 124, 124a is minimised by a reduction in the number of layers of poly-crystalline silicon and therefore step coverage for such connections is improved, so that the incidence of electro-migration and other similar problems becomes low. Thus, the single layer gate structure is very effective for increasing the integration density, improving performance and raising the production yield.

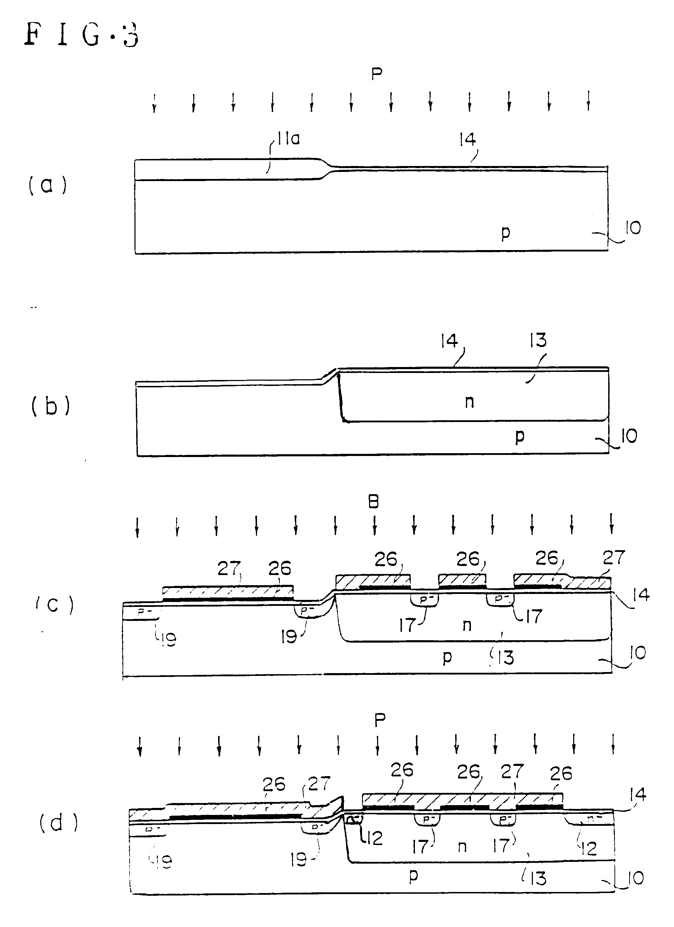

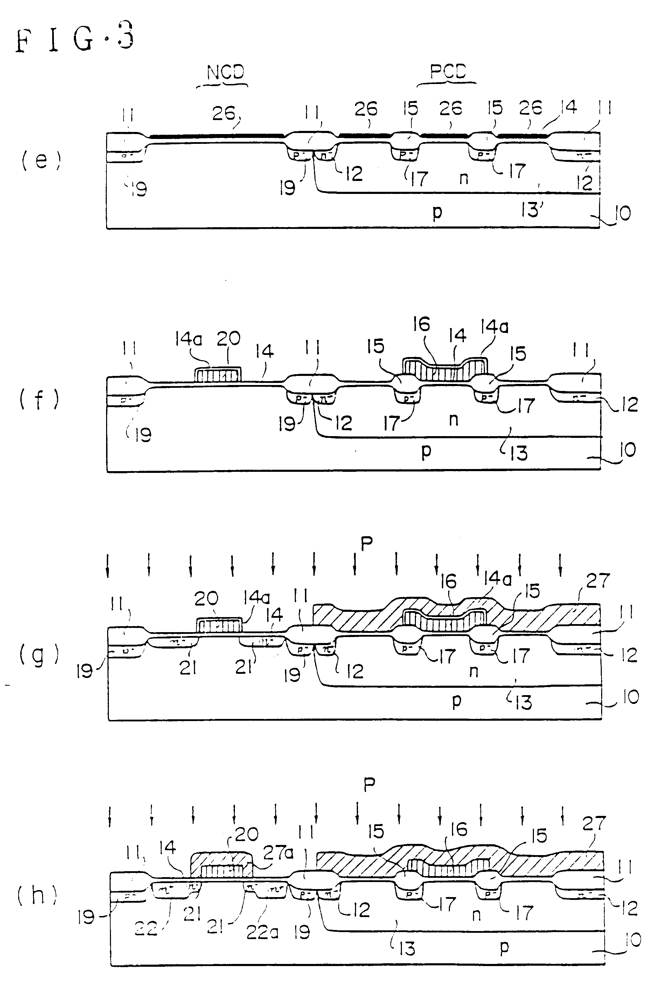

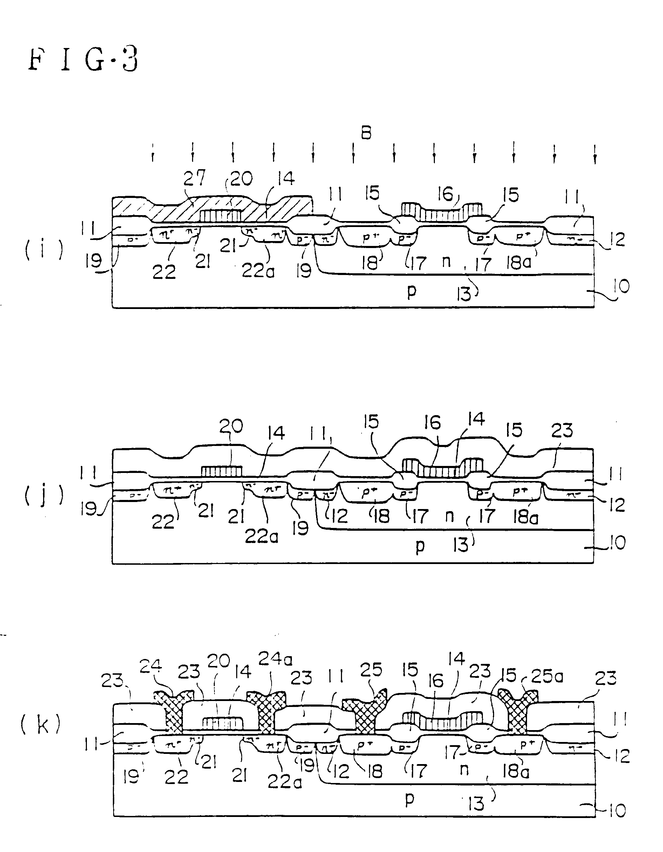

Figures 3 (a) to 3 (k) are sectional views showing sequentially the steps in a method of manufacturing high breakdown voltage CMOS transistors similar to those shown in Figure 1 according to the present invention. It should be noted that in these Figures the elements or portions which are identical or equivalent of those shown in Figure 1 are denoted by the same reference numerals for the sake of convenience.

Referring firstly to Figure 3 (a), the surface of a p-type silicon substrate 10 except for an n-well forming region is subjected to wet oxidation at 1000°C by the use of a local oxidation technique to form a silicon oxide film 11a having a thickness of about 5000 Angstrom. The n-well forming region is subjected to dry oxidation at 1000°C to form a silicon oxide film 14 having a thickness of about 400 Angstrom. Thereafter, ion implantation of phosphorous (P) ions is effected through the silicon oxide film 14 under the conditions of 120 keV and 5 x 10¹² cm⁻². Treatment is then carried out for thirteen hours in a nitrogen (N₂) atmosphere containing 10% oxygen (O₂) at 1160°C, thereby activating the phosphorous ions driven into the n-well forming region and thus forming an n-well 13, as shown in Figure 3 (b).

Next, the silicon oxide films 11a and 14 are removed, and the surface of the substrate 10 is again subjected to dry oxidation at 1000°C to form another silicon oxide film 14 having a thickness of about 400 Angstrom, as shown in Figure 3 (b).

A silicon nitride film is now deposited on the whole surface, and is photo-etched to leave the silicon nitride film only in element forming regions 26 as shown in Figure 3 (c). After this, a resist 27 is coated on the whole surface and is subjected to photo-etching to provide openings therein at regions where p-type stoppers are to be formed. Thereafter, ion implantation of boron (B) ions is effected under the conditions of 35 keV and 3 x 10¹⁴ cm⁻², the resist 27 is then removed and heat treatment is carried out to form p⁻-type off-set regions 17 and p⁻-type channel stopper regions 19.

Another resist 27 is then coated on the surface and is subjected to photo-etching to provide openings therein at regions where n-type stoppers are to be formed, as shown in figure 3 (d). Thereafter, ion implantation of phosphorous ions is effected under the conditions of 80 keV and 2 x 10¹³ cm⁻², the resist 27 is removed, and heat treatment is carried out to form n⁺-type channel stopper regions 12.

With the silicon nitride films 26 used as masks, local field oxidation is effected by a wet oxidation process carried out at 950°C to form LOCOS oxide films 11 and 15 having a thickness of about 9000 Angstrom as shown in Figure 3 (e). The oxide film 11 is a LOCOS oxide film for providing element isolation, while the oxide film 15 is a high breakdown voltage LOCOS oxide film for providing gate electrodes (not shown in Figure 3 (e)). Subsequently, the silicon nitride film 26 and the silicon oxide film 14 are successively removed and then dry oxidation is carried out at 1100°C to form a new gate oxide film 14 having a thickness of about 600 Angstrom. Then, a resist is coated on the surface and subjected to photo-etching to provide openings therein at n-channel doped (NCD) regions. Next, ion implantation of phosporous ions is carried out under the conditions of 100 keV and 4 x 10¹¹ cm⁻². Subsequently, a resist is coated on the surface and subjected to photo-etching to provide openings therein at p-channel doped (PCD) regions and then ion implation of boron ions is carried out under the conditions of 40 keV and 5 x 10¹¹ cm⁻². Thus, basic regions of a depletion type MOS device are formed (the illustration of these regions being omitted).

A poly-crystalline silicon layer having a thickness of about 4000 Angstrom is formed on the whole surface and, after phosphorous or arsenic (Aₛ) has been diffused therein so that an n⁺-type poly-crystalline silicon layer is formed, it is subjected to photo-etching using a resist (not shown) to form gate electrodes 16 and 20 of poly-crystalline silicon, as shown in Figure 3 (f). Subsequently, light oxide films 14a are formed so as to cover the gate electrodes 16 and 20, respectively, by wet oxidation carried out at 830°C.

As shown in Figure 3 (g), a resist 27 is coated on the surface and provided with openings by photo-etching and, with the gate electrode 20 used as a mask, phosphorous ions are implanted into an n-channel MOS transistor forming region under the conditions of 80 keV and 5 x 10¹² cm⁻² to form n⁻-type diffused layers 21. Thus, foundations for off-set regions are formed.

As shown in Figure 3 (h), a resist 27a that covers the gate electrode 20 is formed by photo-etching and, with this resist 27a used as a mask, ion implantation of phosphorous ions is carried out under the conditions of 80 keV and 4 x 10¹⁵ cm⁻². After the resists 27 and 27a have been removed, heat treatment is carried out to form n⁺-type diffused layers 22 and 22a which serve as source and drain regions. Completion of this step provides a high breakdown voltage masked off-set MOS transistor having an n-channel LDD structure.

Although, in this embodiment, the n⁻-type diffused layers 21 which are defined as off-set regions are masked with the resist 27a, it is also possible to employ as masks side wall insulating films which are provided on the side walls, respectively, of the gate electrode in the process for forming the transistor having the LDD structure.

As shown in Figure 3 (i), a resist 27 is coated only on the n-channel MOS transistor formed as described above by photo-etching. Then, boron ions are implanted under the conditions of 35 keV and 2 x 10¹⁵ cm⁻² by using as masks the gate electrode 16 and the LOCOS oxide films 11 and 15 in a p-channel MOS transistor forming region. After the resist 27 has been removed, heat treatment is carried out to form p⁺-type diffused layers 18 and 18a which serve as source and drain regions. Completion of this step results in a high breakdown MOS transistor having a p-channel LOCOS off-set structure.

As shown in Figure 3 (j), a PSG film for a second field region, which serves an an inter-layer insulating film 23, is deposited on the whole surface. The PSG film may be a BPSG film or may be replaced with a silicon oxide film.

Thereafter, as shown in Figure 3 (k), the inter-layer insulating film 23 is provided with contact holes for leads from the source and drain regions by photoetching according to conventional methods. Then, an Aℓ film for the electrode connections is deposited and patterned by photo-etching, thereby forming Aℓ interconnection films 24, 24a, 25 and 25a, and thus completing the high breakdown voltage CMOS transistors similar to those of the first embodiment shown in Figure 1.

It should be noted that, although in the arrangements shown respectively in Figure 1 and Figures 3 (a) to 3 (k) are masked off-set transistor, which is an n-channel transistor on a p-type semi-conductor substrate, and a LOCOS off-set transistor, which is a p-channel transistor in an n-well region, are provided, it is alternatively possible for an n-channel transistor to be formed in a p-well region provided in an n-type semi-conductor substrate, and another p-channel transistor to be formed on the n-type semi-conductor substrate.

However, if the p-channel transistor is formed with the masked off-set structure, masks will be needed in the steps shown in Figures 3 (g) and 3 (h). Therefore, it is preferable that the p-channel transistor has the LOCOS off-set structure. Conversely, if the n-channel transistor is formed with the LOCOS off-set structure, the step shown in Figure 3 (h) is not needed. However, since the size of each transistor having the LOCOS off-set structure is relatively large, the use of the LOCOS off-set structure for elements that are employed in relatively large numbers, such as transistors in memory cells, results in an increase in the area occupied by these transistors, so that it is impossible to increase the integration density. Therefore, such an arrangement impedes miniaturisation. Consequently, the arrangement shown in Figures 1 and Figures 3 (a) to 3 (k) is preferable for an EEPROM.

More specifically, the most suitable structure for an EEPROM is to form the n-channel transistors, which are required in a relatively large number for the memory cells and a part of the peripheral circuit, so as to have the masked off-set structure, while forming the p-channel transistors, which are required in a relatively small number for a part of the peripheral circuit, so as to have the LOCOS off-set structure. However, in a case where p-channel transistors are required in a larger number than n-channel transistors, it is preferable in contrast for the n-channel transistors to have the LOCOS off-set structure and the p-channel transistors to have the masked off-set structure.

As described above, the present invention, as defined in the attached claims, provides a semi-conductor memory having a peripheral circuit constituted by CMOS devices, wherein, for example, n-channel high breakdown voltage transistors, which are required in a relatively large number, are formed with the masked off-set structure, while, for example, p-channel high breakdown voltage transistors, which are required in a relatively small number, are formed with the LOCOS off-set structure, these two different types of transistors being fabricated on the same substrate. The invention also provides a method of manufacturing the above described semi-conductor device.

Thus, the high breakdown voltage transistors which are employed in a relatively large number, and therefore greatly affect the integration density, are formed with the masked off-set structure, which is advantageous from the viewpoint of the integration density. In addition, the high breakdown voltage transistors which are not required in a large number, and therefore do not have a substantial effect on the integration density, are formed with the LOCOS off-set structure, which needs a relatively small number of manufacturing steps and hence involves a relatively low production cost. These two different types of transistors are fabricated on the same substrate. Therefore, it is possible to optimise both the arrangement of semi-conductor device and the method of manufacturing the device in relation to miniaturisation, reduction in the number of masks required and simplification of the manufacturing process. In particular, the present invention may advantageously be applied to, for example, an EEPROM wherein gates are formed from a single layer of poly-crystalline silicon.

## Claims

1. A semi-conductor device having a memory cell region and a peripheral circuit on a common substrate, the memory cell region including a plurality of memory transistors each defined by a first high breakdown voltage transistor (Qn, Qm) of a first conductivity type and a plurality of select transistors each defined by a second high breakdown voltage transistor (Qn, Qw) of the first conductivity type, and the peripheral circuit including a third high breakdown voltage transistor (Qp) of a second conductivity type, wherein the first and second high breakdown voltage transistors each have a first off-set region (21,121) of the first conductivity type defined by a low concentration impurity region having a substantially flat surface, each first off-set region being formed in the substrate (10,110) adjacent to a respective gate electrode (20,120) of the first and second high breakdown voltage transistors, and in that the third high breakdown voltage transistor has a thick insulating film (15) provided adjacent to a gate electrode (16) of the third high breakdown transistor with a part thereof buried in the substrate, and a second off-set region (17) of the second conductivity type defined by a low concentration impurity region provided in the substrate under the thick insulating film.

2. A device according to claim 1, characterised in that the first and second high breakdown voltage transistors are n-channel high breakdown voltage transistors, and in that the third high breakdown voltage transistor is a p-channel high breakdown voltage transistor.

3. A device according to claim 1 or 2, characterised in that the first off-set region is an n-type impurity region, and in that the second off-set region is a p-type impurity region.

4. A method of manufacturing a semi-conductor memory device having a first high breakdown voltage transistor (Qn, Qm, Qw) of a first conductivity type and a second high breakdown voltage transistor (Qp) of a second conductivity type on a common substrate, said method comprising forming a second low impurity off-set region (17) of the second conductivity type in a first conductivity type region (13) of the semi-conductor substrate (10) and a stopper region (19) of the second conductivity type in a second conductivity type region of the semi-conductor substrate; forming a thick insulating film (15) on the second off-set region with a portion thereof buried in the semi-conductor substrate; forming a gate electrode (20) of the first high breakdown voltage transistor above the second conductivity type region of the semiconductor substrate and a gate electrode (16) of the second high breakdown voltage transistor above the first conductivity type region of the semiconductor substrate adjacent the second off-set region; forming a first low impurity off-set region (21) of the first conductivity type in the semi-conductor substrate adjacent the gate electrode of the first high breakdown voltage transistor; forming source and drain regions of the first high breakdown voltage transistor (22,22a) in the semi-conductor substrate adjacent the first off-set region and distal to the gate electrode of the first high breakdown transistor, and forming source and drain regions (18,18a) of the second high breakdown voltage transistor in the semiconductor substrate adjacent to the second off-set region and distal to the gate electrode of the second high breakdown transistor.

## Patentansprüche

1. Halbleiter-Bauelement mit einem Speicherzellenbereich und einer Peripherieschaltung auf einem gemeinsamen Substrat, wobei der Speicherzellenbereich eine Mehrzahl von Speichertransistoren, die jeweils durch einen ersten Transistor (Qn, Qm) hoher Durchbruchspannung eines ersten Leitfähigkeitstyps definiert sind, sowie eine Mehrzahl von Auswahltransistoren umfaßt, die jeweils durch einen zweiten Transistor (Qn, Qw) hoher Durchbruchspannung des ersten Leitfähigkeitstyps definiert sind, und wobei die Peripherieschaltung einen dritten Transistor (Qp) hoher Durchbruchspannung eines zweiten Leitfähigkeitstyps umfaßt, wobei die ersten und zweiten Transistoren hoher Durchbruchspannung jeweils einen ersten abgesetzten Bareich (21, 121) des ersten Leitfähigkeitstyps aufweisen, welcher durch einen Bereich geringer Störstellenkonzentration mit einer im wesentlichen flachen Oberfläche definiert ist, wobei jeder erste abgesetzte Bereich in dem Substrat (10, 110) einer jeweiligen Gate-Elektrode (20, 120) der ersten und zweiten Transistoren hoher Durchbruchspannung benachbart ausgebildet ist, und daß der dritte Transistor hoher Durchbruchspannung einen einer Gate-Elektrode (16) des dritten Transistors hohen Durchbruchs benachbart vorgesehenen dicken Isolierfilm (15), von dem ein Teil in das Substrat eingebettet ist, sowie einen zweiten abgesetzten Bereich (17) des zweiten Leitfähigkeitstyps aufweist, welcher durch einen in dem Substrat unter dem dicken Isolierfilm vorgesehenen Bereich geringer Störstellenkonzentration definiert ist.

2. Bauelement nach Anspruch 1, dadurch gekennzeichnet, daß die ersten und zweiten Transistoren hoher Durchbruchspannung n-Kanal-Transistoren hoher Durchbruchspannung sind und daß der dritte Transistor hoher Durchbruchspannung ein p-Kanal-Transistor hoher Durchbruchspannung ist.

3. Bauelement nach Anspruch 1 oder 2, dadurch gekennzeichnet, daß der erste abgesetzte Bereich ein Störstellenbereich vom n-Typ ist und daß der zweite abgesetzte Bereich ein Störstellenbereich vom p-Typ ist.

4. Verfahren zur Herstellung eines Halbleiter-Speicherbauelements mit einem ersten Transistor (Qn, Qm, Qw) hoher Durchbruchspannung eines ersten Leitfähigkeitstyps und einem zweiten Transistor (Qp) hoher Durchbruchspannung eines zweiten Leitfähigkeitstyps auf einem gemeinsamen Substrat, wobei das Verfahren umfaßt:
Bilden eines zweiten, störstellenarmen abgesetzten Bereichs (17) des zweiten Leitfähigkeitstyps in einem Bereich (13) des ersten Leitfähigkeitstyps des Halbleitersubstrats (10) und eines Stopperbereichs (19) des zweiten Leitfähigkeitstyps in einem Bereich des zweiten Leitfähigkeitstyps des Halbleitersubstrats;
Bilden eines dicken Isolierfilms (15), von dem ein Teil in das Halbleitersubstrat eingebettet ist, auf dem zweiten abgesetzten Bereich;
Bilden einer Gate-Elektrode (20) des ersten Transistors hoher Durchbruchspannung über dem Bereich des zweiten Leitfähigkeitstyps des Halbleitersubstrats und einer Gate-Elektrode (16) des zweiten Transistors hoher Durchbruchspannung über dem Bereich des ersten Leitfähigkeitstyps des Halbleitersubstrats benachbart dem zweiten abgesetzten Bereich;
Bilden eines ersten störstellenarmen abgesetzten Bereichs (21) des ersten Leitfähigkeitstyps in dem Halbleitersubstrat benachbart der Gate-Elektrode des ersten Transistors hoher Durchbruchspannung;
Bilden von Source- und Drain-Bereichen des ersten Transistors (22, 22a) hoher Durchbruchspannung in dem Halbleitersubstrat benachbart dem ersten abgesetzten Bereich und fern der Gate-Elektrode des ersten Transistors hohen Durchbruchs; und
Bilden von Source- und Drain-Bereichen (18, 18a) des zweiten Transistors hoher Durchbruchspannung in dem Halbleitersubstrat benachbart dem zweiten abgesetzten Bereich und fern der Gate-Elektrode des zweiten Transistors hohen Durchbruchs.

## Revendications

1. Dispositif de semi-conducteur possédant une zone de cellule de mémoire et un circuit périphérique sur un substrat d'usage courant, la zone de cellule de mémoire comportant une pluralité de transistors de mémorisation définis chacun par un premier transistor (Qn, Qm) à tension disruptive élevée d'un premier type de conductivité et une pluralité de transistors de tri définis chacun par un second transistor (Qn, Qw) à tension disruptive élevée du premier type de conductivité, et le circuit périphérique comportant un troisième transistor (Qp) à tension disruptive élevée d'un second type de conductivité, dans lequel les premier et second transistors à tension disruptive élevée possèdent chacun une première zone de décalage (21, 121) du premier type de conductivité définie par une zone d'impureté à faible concentration possédant une surface essentiellement plate, chaque première région de décalage étant formée dans le substrat (10, 110) adjacent à une électrode de grille respective (20, 120) des premier et second transistors à tension disruptive élevée, et le troisième transistor à tension disruptive élevée possèdant une épaisse couche isolante (15) réalisée de façon adjacente à une électrode de grille (16) du troisième transistor à tension disruptive élevée avec une partie de celui-ci encastrée dans le substrat, et une seconde zone de décalage (17) du second type de conductivité définie par une zone d'impureté à faible concentration réalisée dans le substrat sous l'épaisse couche isolante.

2. Dispositif selon la revendication 1, caractérisé en ce que le premier et le second transistor à tension disruptive élevée sont des transistors à canal N à tension disruptive élevée et en ce que le troisième transistor à tension disruptive élevée est un transistor à canal P à tension disruptive élevée.

3. Dispositif selon la revendication 1 ou 2, caractérisé en ce que la première zone de décalage est une zone d'impureté du type N, et en ce que la deuxième zone de décalage est une zone d'impureté du type P.

4. Procédé de fabrication d'un dispositif mémoire semi-conducteur possédant un premier transistor (Qn, Qm, Qw) à tension disruptive élevée d'un premier type de conductivité et un second transistor (Qp) à tension disruptive élevée d'un second type de conductivité sur un substrat d'usage courant, ledit procédé comprenant la formation d'une seconde zone de décalage (17) de faible impureté du second type de conductivité dans une zone (13) du premier type de conductivité du substrat semi-conducteur (10) et une zone d'arrêt (19) du second type de conductivité dans une zone du second type de conductivité du substrat semi-conducteur ; la formation d'une épaisse couche isolante (15) sur la seconde zone de décalage avec une partie de celle-ci encastrée dans le substrat semi-conducteur ; la formation d'une électrode de grille (20) du premier transistor à tension disruptive élevée au-dessus de la zone du second type de conductivité du substrat semi-conducteur et une électrode de grille (16) du second transistor à tension disruptive élevée au-dessus de la zone du premier type de conductivité du substrat semi-conducteur adjacent à la seconde zone de décalage ; la formation d'une première zone de décalage de faible impureté (21) du premier type de conductivité dans le substrat semi-conducteur adjacent à l'électrode de grille du premier transistor à tension disruptive élevée ; la formation de zones source et drain du premier transistor à tension disruptive élevée (22, 22a) dans le substrat semi-conducteur adjacent à la première zone de décalage et distal à l'électrode de grille du premier transistor à tension disruptive élevée, et la formation de zones source et drain (18, 18a) du second transistor à tension disruptive élevée dans le substrat semi-conducteur adjacent à la seconde zone de décalage et distal à l'électrode de grille du second transistor à tension disruptive élevée.
